**Europäisches Patentamt**

**European Patent Office**

**Office européen des brevets**

(11) Numéro de publication : **0 285 532 B1**

(12) **FASCICULE DE BREVET EUROPEEN**

(45) Date de publication du fascicule du brevet :
26.02.92 Bulletin 92/09

(51) Int. Cl.⁵ : **H02H 3/34,** H02J 3/14, G01R 29/16

(21) Numéro de dépôt : **88420104.7**

(22) Date de dépôt : **29.03.88**

(54) **Dispositif de détection de défaut dans un réseau triphasé alimentant des charges par des trains d'ondes entières.**

Priorité : **30.03.87 FR 8704588**

(43) Date de publication de la demande :
**05.10.88 Bulletin 88/40**

(45) Mention de la délivrance du brevet :
**26.02.92 Bulletin 92/09**

(84) Etats contractants désignés :
**DE ES FR GB IT SE**

(56) Documents cités :
**FR-A- 2 034 094
FR-A- 2 306 569
US-A- 4 067 053
US-A- 4 245 319**

Titulaire : **EUROTHERM AUTOMATION S.A., Société Anonyme:
Parc d'Affaires de Dardilly 6, chemin des Joncs B.P. 55
F-69572 Dardilly Cédex (FR)**

Inventeur : **Picavet, Michel
Hameau de Mosouvre Lentilly
F-69210 l'Arbresle (FR)**
Inventeur : **Level, Yves
475, route des Condamines
F-69390 Vernaison (FR)**

(74) Mandataire : **Ropital-Bonvarlet, Claude
Cabinet BEAU DE LOMENIE, 51, avenue Jean-Jaurès
F-69007 Lyon (FR)**

**Description**

La présente invention a pour objet un dispositif de détection de défaut dans un réseau triphasé sans fil neutre d'alimentation de charges, comportant des moyens de détection du déséquilibre de charge commandés en entrée par des signaux délivrés par des transformateurs d'intensité et représentatifs des courants circulant dans les lignes d'alimentation, ces moyens comprenant un circuit déphaseur constitué d'un amplificateur opérationnel monté en inverseur avec une résistance d'entrée et une boucle de contre-réaction négative comportant un réseau parallèle composé d'au moins une branche résistive et une branche capacitive.

Les charges peuvent être constituées, par exemple, par des résistances de chauffage, des éléments émetteurs infrarouge, des électrolytes ou, d'une manière générale, par tout autre type d'impédance.

Dans certains cas, par exemple pour des fours, les éléments chauffants présentent une faible inertie thermique et nécessitent une alimentation par des séries de trains d'onde de courte durée qui permettent d'éviter des variations importantes de la température et du rayonnement infrarouge émis.

On réalise, souvent, un montage triphasé d'alimentation de charges comportant, pour des raisons économiques, uniquement deux couples de thyristors montés en anti-parallèles et contrôlant deux phases différentes de la tension d'alimentation triphasée, pour assurer une alimentation pulsée de la charge.

Il est important de pouvoir détecter toute anomalie pouvant survenir dans le fonctionnement d'une telle alimentation, soit par défaillance d'un thyristor, soit par une surcharge, soit par une rupture d'une charge dans une branche.

Un contrôle de l'intensité du courant dans chacune des lignes d'alimentation est difficile, du fait des variations introduites par la régulation elle-même, de la difficulté à comparer entre eux avec une bonne sensibilité des signaux de valeur élevée et de la non accessibilité aisée à la ligne directe d'alimentation.

Dans un réseau triphasé, il apparaît que la composante symétrique inverse du courant est nulle lorsque le réseau est équilibré. Par conséquent, il peut être envisagé de déceler un déséquilibre de charges par la mesure de la composante inverse du courant.

Cette composante du courant, qui est fonction des courants circulant dans les lignes d'alimentation, peut être déterminée à partir des valeurs des courants circulant dans deux lignes d'alimentation, dans la mesure où le courant de la troisième ligne d'alimentation peut s'exprimer en fonction des courants dans les deux premières lignes, en l'absence de neutre.

On peut donc envisager une méthode de détection du déséquilibre de charge consistant à combiner les courants circulant dans deux lignes d'alimentation seulement.

On a déjà proposé des dispositifs de détection du déséquilibre de charge en utilisant des réseaux de résistances et d'inductances. Ces dispositifs ne donnent, toutefois, pas satisfaction en pratique, en raison de la présence des inductances qui sont de mise en oeuvre toujours délicate. De plus, ces dispositifs ne possèdent pas une bonne sensibilité de mesure, ce qui les rend inadaptés à détecter un faible déséquilibre de charge.

Par ailleurs, on connaît, par le brevet **US 4 067 063**, un dispositif, comportant des amplificateurs, des résistances et des capacités, destiné à assurer la détection du déséquilibre de réseaux ou de charges fonctionnant en régime permanent.

Un tel dispositif ne peut nullement assumer une fonction de détection du déséquilibre de charges lorsque ces dernières sont alimentées par des trains d'ondes entières. En effet, dans un tel mode de fonctionnement, visant à éliminer la génération de parasites sur le réseau, le déclenchement de la fermeture ou de l'ouverture des interrupteurs s'effectue lors du passage à zéro de la tension aux bornes des interrupteurs dans le cas de charges résistives ou, plus généralement, à des instants différents. Il s'ensuit donc des décalages d'amorçage et d'extinction entre les deux interrupteurs pendant des périodes données au cours desquelles le régime est monophasé, puisqu'un seul interrupteur conduit. Un tel régime déséquilibré, qui ne correspond pas à des défauts dans le réseau d'alimentation des charges, mais résulte du mode particulier de commande des interrupteurs, est détecté par le dispositif, ce qui correspond à une erreur certaine de mesure.

Par ailleurs, un tel dispositif comporte un déphaseur présentant un régime transitoire important ne permettant pas d'obtenir une bonne sensibilité de mesure.

La présente invention a pour but de remédier aux inconvénients précités, en proposant un dispositif de détection de déséquilibre dans un réseau triphasé alimentant des charges par des trains d'ondes entières, présentant une sensibilité élevée de détection et une mise en oeuvre simple et rapide et apte à assurer la fonction de détection du déséquilibre uniquement pendant la durée où le régime électrique est triphasé.

Ces buts sont atteints grâce à un dispositif de détection de défauts comprenant les caractéristiques du préambule de la revendication 1 caractérisé en ce que des moyens détectent un déséquilibre pour des charges alimentées par des trains d'ondes entières et comportent :

– un premier transformateur d'intensité associé à une première ligne d'alimentation comportant un premier bloc à thyristors de contrôle de la puissance des charges interposées,

– un second transformateur d'intensité associé à une seconde ligne d'alimentation comportant un second bloc à thyristors,

– un circuit déphaseur du signal délivré par le premier transformateur,

– des moyens de combinaison du signal issu du circuit déphaseur et du signal délivré par le second transformateur,

la sortie du moyen de combinaison étant reliée à

– un premier circuit amplificateur, suivi par

– un circuit redresseur,

– un circuit intégrateur, et

– un étage à détection de seuil au-delà duquel un déséquilibre de charge est détecté,

– et des moyens de validation de la détection du déséquilibre uniquement pendant la conduction simultanée des deux blocs à thyristors correspondant à un régime établi en triphasé.

Diverses autres caractéristiques ressortent de la description faite ci-dessous en référence aux dessins annexés qui montrent, à titre d'exemples non limitatifs, des formes de réalisation de l'objet de l'invention.

La fig. 1 illustre un réseau triphasé d'alimentation d'une charge équipé d'un dispositif de détection du déséquilibre de charge conforme à l'invention.

La fig. 2 représente un schéma-bloc d'un dispositif de détection du déséquilibre selon l'invention.

La fig. 3A illustre la forme des courants d'alimentation de la charge selon un mode particulier de commande des interrupteurs associés aux lignes.

Les fig. 3B et 3C représentent des chronogrammes montrant la mise en oeuvre du dispositif de détection selon le mode de commande des interrupteurs de la fig. 3A.

La fig. 4 représente un exemple de réalisation d'un dispositif de détection conforme à l'invention.

La fig. 5 illustre une variante de réalisation d'un circuit déphaseur du dispositif selon l'invention.

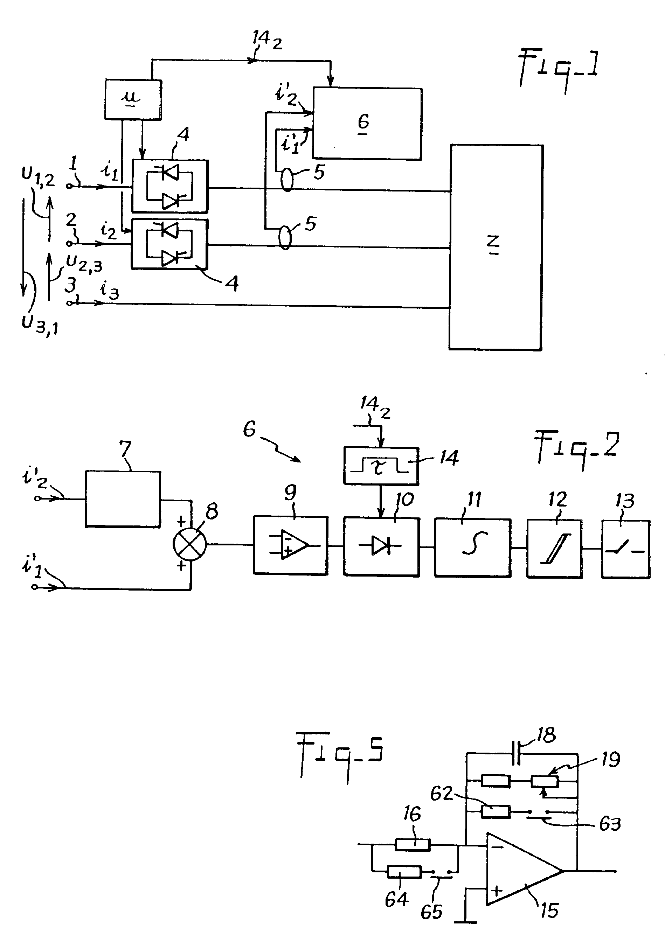

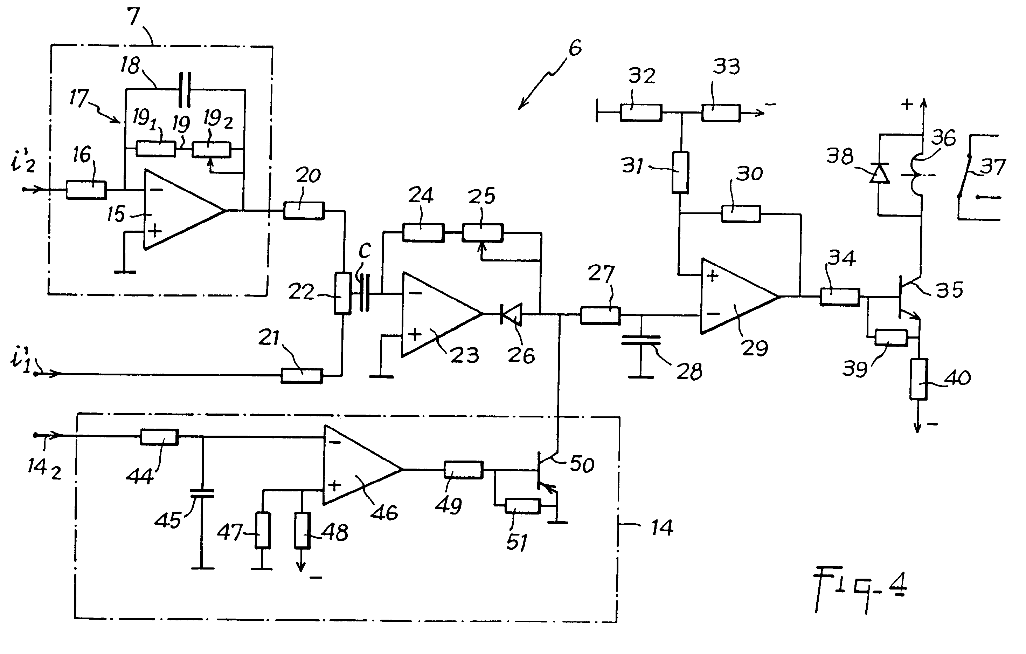

La fig. 1 illustre un réseau triphasé 1, 2, 3 sans fil neutre, présentant des tensions entre phases $U_{1,2}$, $U_{2,3}$ et $U_{3,1}$, destiné à alimenter une charge $\underline{Z}$ pouvant être monté en étoile ou en triangle. Chaque ligne 1, 2, 3 du réseau est parcourue par un courant $i_1$, $i_2$, $i_3$, ces courants étant déphasés entre eux, de façon connue, respectivement de l'opérateur $\underline{a}$, avec $\underline{a} = e^{j2\pi/3}$, soit $i_1 = \underline{a}\, i_2$ et $i_2 = \underline{a}\, i_3$.

Deux des lignes d'alimentation, par exemple les lignes 1 et 2, comportent chacune un bloc 4 de contrôle de la puissance de la charge, utilisé en interrupteur et commandé par une unité de commande $\underline{u}$, connue en soi. Chaque bloc 4 est constitué, par exemple, par un couple de thyristors montés en anti-parallèles, qui assure l'alimentation de la charge par une série de trains d'onde d'une durée courte mais suffisamment longue pour que le régime triphasé puisse être detecté.

Les lignes d'alimentation, équipées des blocs de contrôle 4, sont associées à des transformateurs d'intensité 5 constitués par des enroulements bobinés autour des lignes d'alimentation.

Chaque transformateur d'intensité 5 délivre un courant, directement représentatif du courant d'alimentation de la ligne associée et de faible intensité, en vue d'un traitement logique approprié.

Il est à noter que les transformateurs d'intensité 5 délivrent un courant en phase ou en opposition de phase avec le courant mesuré suivant leurs sens de branchement. Par exemple, les transformateurs 5 génèrent $i'_1 = K\, i_1$ et $i'_2 = - K\, i_2$. $i_1$ et $i_2$ sont les courants respectifs des lignes 1 et 2 et K le rapport de transformation des transformateurs d'intensité 5.

Les courants, générés par les transformateurs 5, constituent les données d'entrée de moyens 6 de détection du déséquilibre de charge, qui est susceptible d'apparaître sur une ligne du réseau.

Pour assumer cette fonction de détection du déséquilibre de charge, les moyens 6 détectent l'équilibre entre les deux courants sélectionnés, cet équilibre étant rompu dès l'apparition d'un déséquilibre de charge.

Il est à noter que les moyens 6 sont aptes à déceler un déséquilibre de charge relatif à la ligne d'alimentation 3 non sélectionnée, puisqu'un tel déséquilibre contribue, également, à modifier les courants des lignes sélectionnées 1, 2.

Conformément à la fig. 2, les moyens de détection 6, selon l'invention, comprennent un circuit 7 déphaseur d'un des courants d'une valeur en relation avec le déphasage existant entre les deux courants sélectionnés et un étage 8 chargé de combiner le courant déphasé issu du circuit 7 et le courant sélectionné non déphasé.

Il est à remarquer que les transformateurs d'intensité 5 sont branchés, de manière à fournir, par exemple, des valeurs $i'_1 = K\, i_1$ et $i'_2 = - K\, i_2$ comme illustré à la fig. 1, de sorte que l'étage 8 constitue, dans cette hypothèse, un simple circuit sommateur des courants $i'_1$ et $\underline{a}\, i'_2$ qui représentent, respectivement, les courants $i_1$ et $- \underline{a}\, i_2$ au coefficient K près, en vue de détecter la condition de déséquilibre.

L'écart mesuré, entre les deux courants $i'_1$ et $\underline{a}\, i'_2$ est amplifié par un amplificateur 9, avant d'être redressé par un circuit redresseur 10 et intégré par un circuit intégrateur 11, en vue d'être comparé dans un étage 12 à détection de seuil au-delà duquel un déséquilibre de charge significatif est décelé. Le signal issu de l'étage 12 peut lui-même être appliqué à un étage 13 de commande d'indicateur de déséquilibre.

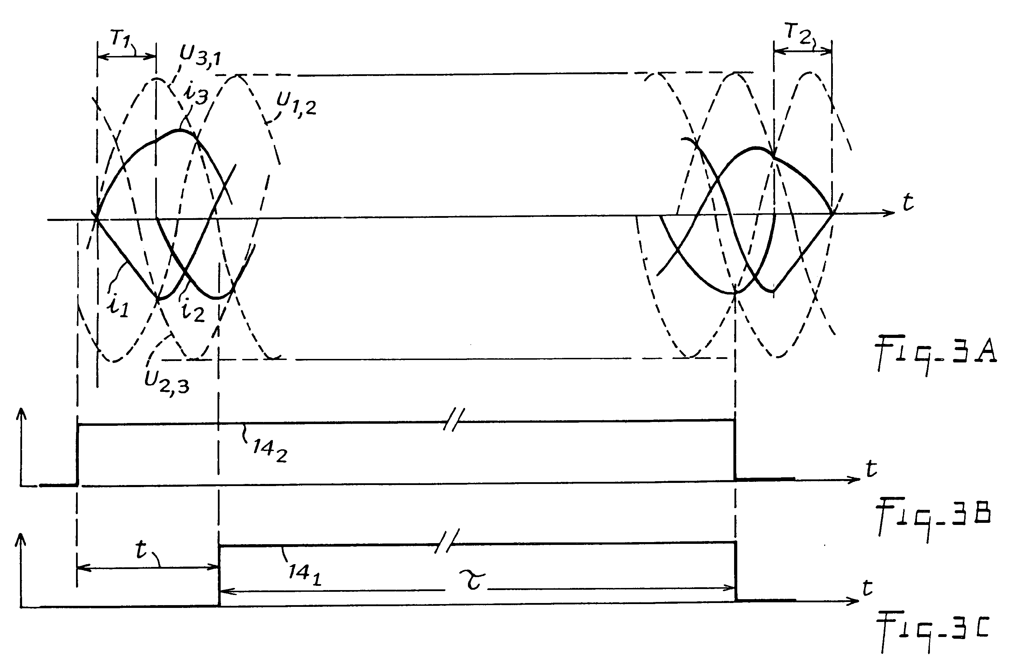

Les moyens de détection 6 comportent des moyens 14 d'autorisation du fonctionnement des moyens 6 lorsque les blocs de contrôle ou les interrupteurs 4 ne sont pas initialisés simultanément, en particulier dans le cas où il est envisagé, en vue d'éliminer les parasites du réseau, le déclenchement de la fermeture des interrupteurs lors du passage à zéro de la tension entre deux phases représentées en trait interrompu sur la fig. 3A.

Il apparaît, selon ce mode de fonctionnement des interrupteurs 4, un déséquilibre pendant toute la durée de conduction d'un seul interrupteur, au cours de laquelle uniquement deux phases, par exemple 1 et 3 sont parcourues par un courant et, notamment, pendant les intervalles de temps $T_1$ et $T_2$ correspondant, respectivement, aux décalages d'amorçage et d'extinction entre les interrupteurs.

Pour éviter que les moyens de détection 6 décèlent ce déséquilibre inhérent au mode de commande des interrupteurs, les moyens 14 autorisent la détection du déséquilibre, uniquement pendant la conduction simultanée des deux interrupteurs 4 correspondant à un régime établi en triphasé.

Pour assumer une telle fonction, les moyens 14 délivrent un signal de validation $14_1$ d'une durée $\tau$, en retard de $\underline{t}$ par rapport à l'apparition d'un signal $14_2$ de commande du premier thyristor, le signal de validation $14_1$ étant généré jusqu'à l'extinction du signal de commande $14_2$, conformément aux fig. 3B et 3C. Le retard $\underline{t}$ est déterminé pour que les moyens 6 détectent le déséquilibre lorsque les deux interrupteurs 4 sont amorcés.

La fig. 4 illustre un exemple de réalisation des moyens de détection 6 destinés à recevoir en entrée, par exemple, les courants $i'_1$ et $i'_2$.

Le circuit déphaseur 7 est constitué d'un amplificateur opérationnel 15 connecté au transformateur d'intensité 6 délivrant le courant $i'_2 = - K\, i_2$ par une résistance d'entrée 16 montée sur l'entrée inverseuse de l'amplificateur, l'entrée non inverseuse étant reliée à la masse.

L'amplificateur 15 possède une boucle 17 de contre-réaction négative, composée d'un réseau parallèle comportant une branche capacitive 18 et une branche résistive 19, de préférence adjustable, composée d'une résistance $19_1$ montée en série avec un potentiomètre $19_2$, en vue de compenser les tolérances sur les composants et les variations de fréquences qui introduisent une erreur dans la mesure.

La boucle de contre-réaction 17 introduit un déphasage de - 60 degrés qui, combiné au déphasage de - 180 degrés créé par le montage en inverseur de l'amplificateur, permet de réaliser un déphasage de - 240 ou de + 120 degrés correspondant à l'opérateur $\underline{a}$.

A cet effet, les résistances $R_{16}$ et $R_{19}$, ainsi que la capacité $C_{18}$, possèdent les caractéristiques suivantes :

$$R_{16} = R_{19}/2 \quad \text{et} \quad C_{18} = 3^{\frac{1}{2}}/(R_{19}.\omega)$$

$\omega$ étant la pulsation du réseau.

La sortie de l'amplificateur 15 est connectée à une résistance d'entrée 20 de l'étage sommateur 8 qui possède aussi une autre résistance d'entrée 21, connectée au transformateur d'intensité délivrant le courant $i'_1$. Les résistances d'entrées 20, 21 sont reliées à un potentiomètre 22 délivrant, en sortie, un signal significatif de l'écart E existant entre les deux courants sélectionnés, à savoir : $E = i'_1 + \underline{a}\, i'_2 = K\, (i_1$

$- \underline{a}\, i_2)$.

La sortie du potentiomètre 22 est reliée, par une capacité de découplage $\underline{C}$, à l'entrée inverseuse d'un amplificateur opérationnel 23 dont l'entrée non inverseuse est reliée à la masse. La capacité $\underline{C}$ permet d'éliminer le régime transitoire du circuit déphaseur 7 et d'améliorer ainsi la sensibilité de mesure des moyens 6.

L'amplificateur 23 possède une boucle de contre-réaction négative de réglage de gain composée d'une résistance 24 en série avec un potentiomètre 25 connecté à la sortie de l'amplificateur par une diode 26 polarisée en inverse, destinée à redresser le signal.

L'anode de la diode 26 est reliée à une résistance 27 du circuit intégrateur 11 qui possède aussi un condensateur 28 relié à la masse, dont le point commun avec la résistance 27 est connecté à l'entrée inverseuse d'un amplificateur opérationnel 29 autour duquel est bâti l'étage 12 à détection de seuil à hystérésis.

L'entrée non inverseuse de l'amplificateur 29 est reliée, d'une part, à la sortie de ce même amplificateur 29 par une résistance 30 et, d'autre part, à un réseau diviseur de tension destiné à définir le seuil au-delà duquel le réseau est considéré en déséquilibre.

Le réseau diviseur de tension est composé d'une résistance 31 reliée à la masse par une résistance 32 et à une borne négative par une résistance 33.

La sortie de l'amplificateur 29 est connectée par une résistance 34 à la base d'un transistor 35 d'amplification, en vue de disposer d'un signal utilisable d'alimentation d'une bobine 36 d'un relais 36, 37 dont le contact 37 commande un dispositif de signalisation de défaut.

Le collecteur du transistor 35 est connecté à une borne positive de la tension d'alimentation du montage, par l'intermédiaire de la bobine 36 du relais connecté en parallèle sur une diode de protection 38.

Le transistor 35 est polarisé de façon classique par des résistances 39, 40.

Les moyens de validation 14 reçoivent en entrée le signal de commande $14_2$ délivré par l'unité $\underline{u}$. Les moyens 14 comportent, par exemple, un intégrateur formé par une résistance d'entrée 44 connectée à la masse par un condensateur 45. Le point commun de la résistance 44 et du condensateur 45 est relié à l'entrée inverseuse d'un amplificateur opérationnel 46 monté en comparateur. L'entrée non inverseuse de l'amplificateur 46 est reliée à la masse par une résistance 47 et à la tension négative par une résistance 48. La sortie de l'amplificateur 46 est reliée, par une résistance 49, à la base d'un transistor 50 dont le collecteur est connecté à l'anode de la diode 26. Le transistor 50, qui est polarisé entre son émetteur et sa base par une résistance 51, bloque ou non le signal délivré par le redresseur, en vue d'autoriser ou non la détection du déséquilibre par les moyens 6.

Ainsi, les moyens 6, assurent la détection du déséquilibre de charge apparaissant sur le réseau avec une bonne sensibilité et d'une façon simple, que lorsque la charge est alimentée par le réseau triphasé.

La fig. 5 illustre une autre variante de réalisation du circuit 7 déphaseur, adapté, plus particulièrement, pour fonctionner selon deux fréquences déterminées, par exemple 50 Hz et 60 Hz.

A cet effet, le réseau de contre-réaction du circuit 7, formé d'une branche résistive 19 et d'une branche capacitive 18, comporte aussi, en parallèle, une résistance 62 placée en série avec un interrupteur 63, tandis que la résistance d'entrée 16 de l'amplificateur 15 comporte, en parallèle, une résistance 64 montée en série avec un interrupteur 65.

Les interrupteurs 63 et 65 sont commandés, simultanément, à volonté selon la fréquence utilisée.

## Revendications

1. Dispositif de détection de défaut dans un réseau triphasé (1, 2, 3) sans fil neutre d'alimentation de charges, comportant des moyens de détection du déséquilibre de charge commandés en entrée par des signaux délivrés par des transformateurs d'intensité et représentatifs des courants circulant dans les lignes d'alimentation, ces moyens comprenant un circuit déphaseur (7) constitué d'un amplificateur opérationnel (15) monté en inverseur avec une résistance d'entrée (16) et une boucle (17) de contre-réaction négative comportant un réseau parallèle composé d'au moins une branche résistive (19) et une branche capacitive (18),

caractérisé en ce que les moyens (7) détectent un déséquilibre pour des charges alimentées par des trains d'ondes entières et comportent :

– un premier transformateur d'intensité (5) associé à une première ligne d'alimentation comportant un premier bloc (4) à thyristors de contrôle de la puissance des charges interposées,

– un second transformateur d'intensité (5) associé à une seconde ligne d'alimentation comportant un second bloc (4) à thyristors,

– un circuit (7) déphaseur du signal délivré par le premier transformateur,

– des moyens (8) de combinaison du signal issu du circuit déphaseur (7) et du signal délivré par le second transformateur, la sortie du moyen (8) de combinaison étant reliée à

– un premier circuit amplificateur (9), suivi par

– un circuit redresseur (10),

– un circuit intégrateur (11), et

– un étage (12) à détection de seuil au-delà duquel un déséquilibre de charge est détecté,

– et des moyens (14) de validation de la détection du déséquilibre uniquement pendant la conduction simultanée des deux blocs (4) correspondant à un régime établi en triphasé.

2. Dispositif selon la revendication 1, caractérisé en ce que les moyens de validation (14) comportent un intégrateur (44, 45,) un comparateur (46) et un transistor (50) de blocage ou non du signal délivré par le redresseur (10).

3. Dispositif selon la revendication 1, caractérisé en ce que les moyens de combinaison (8) sont reliés au circuit redresseur par une capacité de découplage (C) destinée à éliminer le régime transitoire du circuit déphaseur (7).

4. Dispositif selon la revendication 1, caractérisé en ce que le circuit déphaseur (7) comporte une résistance d'entrée (16) présentant une impédance ohmique ($R_{16}$) égale à la moitié de celle ($R_{19}$) de la branche résistive (19) et une branche capacitive (18) dont la capacité est égale à $3^{\frac{1}{2}}/(R_{19}.\omega)$, où $\omega$ représente la pulsation du réseau triphasé.

5. Dispositif selon la revendication 1, caractérisé en ce que la boucle de contre-réaction (17) possède une branche composée d'une résistance (62) placée en série avec un interrupteur (63) et en ce que la résistance d'entrée (16) possède une branche parallèle composée d'une résistance (64) montée en série avec un interrupteur (65).

6. Dispositif selon la revendication 1, caractérisé en ce que les moyens de combinaison (8) comprennent un circuit sommateur formé à partir de résistances (20, 22).

7. Dispositif selon la revendication 1, caractérisé en ce que le circuit intégrateur (11) est un réseau (27, 28) résistif-capacitif.

8. Dispositif selon l'une des revendications 1 à 7, caractérisé en ce que l'étage (12) à détection de seuil est relié à un second amplificateur (13) de commande de moyens de signalisation.

## Patentansprüche

1. Einrichtung zur Fehlererfassung in einem Dreiphasennetz (1, 2, 3) ohne Nulleiter für die Versorgung von Lasten, mit Mitteln zur Erfassung einer Last-Fehlanpassung, die an ihrem Eingang durch Signale gesteuert werden, die von Stromwandlern geliefert werden und die in den Versorgungsleitungen fließende Ströme darstellen, wobei diese Mittel eine Phasenschieberschaltung (7) umfassen, die von einem Operationsverstärker (15), an dessen nichtinvertierendem Eingang ein Eingangswiderstand (16) angeschaltet ist, und von einer negativen Rückkopplungsschleife, die ein aus wenigstens einem Widerstandszweig (19) und einem kapazitiven Zweig (18) aufgebautes paralleles Netzwerk aufweist, gebildet wird,

dadurch gekennzeichnet, daß die Mittel (7) eine Fehlanpassung für die mit Vollwellenzügen versorgten Lasten feststellen und umfassen:

   – einen ersten Stromwandler (5), der einer ersten Versorgungsleitung zugeordnet ist, die einen ersten Block (4) mit Thyristoren für die Steuerung der Leistung der dazwischengeschalteten Lasten aufweist,

   – einen zweiten Stromwandler (5), der einer zweiten Versorgungsleitung zugeordnet ist, die einen zweiten Block (4) mit Thyristoren aufweist,

   – eine Phasenschieberschaltung (7) für das vom ersten Stromwandler gelieferte Signal,

   – Mittel (8) für die Kombination des von der Phasenschieberschaltung (7) ausgegebenen Signals mit dem vom zweiten Stromwandler gelieferten Signal,

   – wobei der Ausgang der Kombinationsmittel (8) mit einer ersten Verstärkerschaltung (9), gefolgt von

   – einer Gleichrichterschaltung (10),

   – einer Integratorschaltung (11) und

   – einer Stufe (12) für die Erfassung einer Schwelle, oberhalb derer eine Last-Fehlanpassung festgestellt wird, verbunden ist,

   – und Mittel (14) für die Validierung der eindeutigen Feststellung einer Fehlanpassung während des gleichzeitigen Durchlaßzustandes der zwei Blöcke (4), der einem eingestellten Dreiphasen-Betriebszustand entspricht.

2. Einrichtung gemäß Anspruch 1, dadurch gekennzeichnet, daß die Validierungsmittel (14) einen Integrator (44, 45), einen Komparator (46) und einen Transistor (50) für die Sperrung oder Nichtsperrung des vom Gleichrichter (10) gelieferten Signals aufweisen.

3. Einrichtung gemäß Anspruch 1, dadurch gekennzeichnet, daß die Kombinationsmittel (8) über eine Entkopplungskapazität ($\underline{C}$), die dazu bestimmt ist, den Einschwingzustand der Phasenschieberschaltung (7) zu beseitigen, mit der Gleichrichterschaltung (10) verbunden sind.

4. Einrichtung gemäß Anspruch 1, dadurch gekennzeichnet, daß die Phasenschieberschaltung (7) einen Eingangswiderstand (16), der eine ohmsche Impedanz ($R_{16}$), die gleich der Hälfte derjenigen ($R_{19}$) des Widerstandszweiges (19) ist, und einen kapazitiven Zweig (18), dessen Kapazität gleich $3^{\frac{1}{2}}/(R_{19}\cdot\omega)$ ist, aufweist, wobei $\omega$ die Frequenz des Dreiphasennetzes darstellt.

5. Einrichtung gemäß Anspruch 1, dadurch gekennzeichnet, daß die Rückkopplungsschleife (17) einen Zweig besitzt, der aus einem mit einem Unterbrecher (63) in Reihe geschalteten Widerstand (62) aufgebaut ist, und daß der Eingangswiderstand (16) einen parallelen Zweig besitzt, der aus einem mit einem Unterbrecher (65) in Reihe geschalteten Widerstand (64) aufgebaut ist.

6. Einrichtung gemäß Anspruch 1, dadurch gekennzeichnet, daß die Kombinationsmittel (8) eine anhand von Widerständen (20, 22) gebildete Summationsschaltung umfassen.

7. Einrichtung gemäß Anspruch 1, dadurch gekennzeichnet, daß die Integrationsschaltung (11) ein Netzwerk (27, 28) von Widerständen und Kapazitäten ist.

8. Einrichtung gemäß einem der Ansprüche 1 bis 7, dadurch gekennzeichnet, daß die Stufe (12) für die Schwellenerfassung mit einem zweiten Verstärker (13) für die Steuerung der Signalgebungsmittel verbunden ist.

## Claims

1. Means for the detection of faults in a three-phase system (1, 2, 3) without a neutral under load, comprising means for detecting imbalances in load whose inputs are controlled by signals from current transformers representing the current in the supply lines, these means comprising a phase-shift circuit (7) comprising an operational amplifier (15) fitted as an inverter with an input resistance (16) and a negative feedback loop (17) comprising a parallel system consisting of at least one resistive arm (19) and one capacitive arm (18),

characterised in that the means (7) detect an imbalance in the loads supplied by intact wave trains and comprise:

   – a first current transformer (5) associated with a first supply line comprising a first thyristor block (4) controlling the power of the inserted loads,

   – a second current transformer (5) associated with a second supply line comprising a second thyristor block (4),

   – a phase-shift circuit (7) for the signal issuing from the first transformer,

   – means (8) for combining the signal from the phase-shift circuit (7) and the signal issuing from the second transformer, the output from the combination means being connected to

   – a first amplifier circuit (9), followed by

   – a rectifier circuit (10),

   – an integrated circuited (11), and

   – a stage (12) for detecting the threshold above which load imbalance is detected,

   – and means (14) for validating the load imbalance detected only while the simultaneous conduction of the two blocks (4) corresponds to an established three-phase condition.

2. Means according to claim 1, characterised in that the validation means (14) comprise an integrator (44, 45), a comparator (46) and a transistor (50) which may or may not block the signal from the rectifier (10).

3. Means according to claim 1, characterised in that the combination means (8) are connected to the rectifier circuit by a decoupling capacitance (C) designed to cut out transitional conditions in the phase-shift circuit (7).

4. Means according to claim 1, characterised in that the phase-shift circuit (7) comprises an input resistance (16) which has an ohmic impedance ($R_{16}$) equal to half the resistance ($R_{19}$) of the resistive arm (19) and a capacitive arm (18) whose capacitance is equal to $3^{\frac{1}{2}}/(R_{19}.\omega)$ where $\omega$ represents the frequency of the three-phase system.

5. Means according to claim 1, characterised in that the negative feedback loop (17) has an arm consisting of a resistance (62) placed, in series with a switch (63) and in that the input resistance (16) has a parallel arm consisting of a resistance (64) mounted in series with a switch (65).

6. Means according to claim 1, characterised in that the combination means (8) comprise an adder circuit formed from resistances (20, 22).

7. Means according to claim 1, characterised in that the integrated circuit (11) is a resistance-capacitance system (27, 28).

8. Means according to one of claims 1 to 7, characterised in that the threshold detection stage (12) is connected to a second amplifier (13) controlling the signalling means.

Fig-1

Fig-2

Fig-5

Fig-4

EP 0 285 532 B1

Fig. 3A

Fig. 3B

Fig. 3C